# EUROPEAN PATENT SPECIFICATION

(11) **EP 2 012 215 B1**
(45) Date of publication and mention of the grant of the patent: **29.09.2010**
(21) Application number: 08166615.8
(22) Date of filing: 07.10.2005
(51) Int. Cl.: G06F 1/16, H01M 2/10, H04B 1/38, H04M 1/02, H05K 5/00

(54) **Portable Electronic Device with Versatile Battery Compartment**
Tragbare elektronische Vorrichtung mit vielseitigem Batteriefach
Dispositif électronique portable doté d'un compartiment de batterie polyvalent

(43) Date of publication of application: 07.01.2009
(62) Divisional of application: 07104434.1
(73) Proprietor: RESEARCH IN MOTION LIMITED, Waterloo, Ontario N2L 3W8 (CA)
(72) Inventor: Ladouceur, Norman, Waterloo Ontario N2T 1A2 (CA); Griffin, Jason, Kitchener Ontario N2P 2L3 (CA); Tyneski, Frank, Solana Beach 92075 (CA)
(74) Representative: Rickard, David John

(56) References cited:
- EP-A- 1 603 246
- US-A- 6 048 642
- US-B1- 6 203 363
- US-B2- 6 712 643

## Description

This invention relates to generally portable electronic devices, including but not limited to handheld wireless communication devices. More particularly, this invention relates to means of accommodating batteries of different sizes in such devices.

Certain portable electronic devices, handheld wireless communication devices in particular, are designed to provide various battery life options, depending on different capacity batteries being used. Batteries of different capacity tend to have different physical dimensions. These differences in dimension are typically compensated for by providing battery area access doors of varying dimension, i.e. a separate battery door for each possible battery. It would be preferable to avoid such separate battery doors.

US-A-6048642 discloses a portable electronic device having a battery compartment with a removable cover able to slide relative to the battery compartment to accommodate batteries of different thickness.

EP-A-1603246 discloses a portable electronic device having a battery compartment with a removable cover. This document falls under the provisions of Article 54(3)EPC.

The invention therefore preferably provides various means for accommodating batteries of different dimensions, without requiring separate battery doors.

Reference will be made to "relatively thin" batteries, and "somewhat thicker" batteries. It should be understood that "relatively thin" means relative to the thickness of the "somewhat thicker" batteries, and is not intended to indicate that the "relatively thin" battery is in fact thin compared to batteries in general.

### GENERAL

According to one exemplary embodiment of the invention as claimed there may be provided a portable electronic device comprising a battery compartment and a removable cover therefor, said battery compartment and cover being configured to engage each other in one of at least two discrete relative positions, each said position providing a different battery compartment depth to accommodate batteries of different sizes, wherein the cover has a generally rigid outer frame and a generally rigid centre portion securable to said outer frame in either one of at least two positions, each said position corresponding to a different battery thickness.

According to another exemplary embodiment of the invention as claimed, the cover may have engagement elements extending outwardly therefrom, to engage recesses in side walls of said battery compartment, said engagement elements located away from a centre plane of said cover, whereby rotation of said cover between alternate orientations about an axis in the plane of the cover produces a smaller battery compartment in one orientation than in the other orientation.

Aspects of the invention will be described or will become apparent in the course of the following detailed description and drawings of specific embodiments of which only one is in accordance with the invention, as examples only.

### BRIEF DESCRIPTION OF THE DRAWINGS

An embodiment of the invention will now be described, by way of example only, with reference to the attached drawings, in which:

Fig. 1 is a perspective view of a first exemplary embodiment;

Fig. 2 is a cross-sectional elevation view of the first embodiment, with a relatively thin battery;

Fig. 3 is a cross-sectional elevation view of the first embodiment, with a somewhat thicker battery;

Fig. 4 is a perspective view of a second embodiment, with a relatively thin battery;

Fig. 5 is another perspective view of the second embodiment, with a somewhat thicker battery;

Fig. 6 is a cross-sectional elevation view of the second embodiment, with a relatively thin battery;

Fig. 7 is a cross-sectional elevation view of the second embodiment, with a somewhat thicker battery;

Fig. 8 is a perspective view of a third embodiment, with a relatively thin battery;

Fig. 9 is another perspective view of the third embodiment, with a somewhat thicker battery;

Fig. 10 is a cross-sectional elevation view of the third embodiment, with a relatively thin battery;

Fig. 11 is a cross-sectional elevation view of the third embodiment, with a somewhat thicker battery;

Fig. 12 is a perspective view of a fourth embodiment;

Fig. 13 is a cross-sectional elevation view of the fourth embodiment, with a relatively thin battery;

Fig. 14 is a cross-sectional elevation view of the fourth embodiment, with a somewhat thicker battery;

Fig. 15 is a perspective view of a fifth embodiment, with a relatively thin battery;

Fig. 16 is another perspective view of the fifth embodiment, with a somewhat thicker battery;

Fig. 17 is a cross-sectional elevation view of the fifth embodiment, with a relatively thin battery;

Fig. 18 is a cross-sectional elevation view of the fifth embodiment, with a somewhat thicker battery;

Fig. 19 is a cross-sectional elevation view of a sixth embodiment, similar to the fifth embodiment, with a relatively thin battery;

Fig. 20 is a cross-sectional elevation view of the sixth embodiment, with a somewhat thicker battery;

Fig. 21 is a perspective view of a seventh embodiment;

Fig. 22 is a cross-sectional elevation view of a portion of the seventh embodiment;

Fig. 23 is a cross-sectional elevation view of the seventh embodiment, with a relatively thin battery;

Fig. 24 is a cross-sectional elevation view of the seventh embodiment, with a somewhat thicker battery;

Fig. 25 is a cross-sectional elevation view of an eighth embodiment which is in accordance with the invention as claimed, with a relatively thin battery;

Fig. 26 is a cross-sectional elevation view of a portion of the cover of the eighth embodiment;

Fig. 27 is a cross-sectional elevation view of the eighth embodiment, with a somewhat thicker battery;

Fig. 28 is a perspective view of the battery cover of a ninth embodiment, in a position for a relatively thin battery;

Fig. 29 is a cross-sectional elevation view the cover, corresponding to Fig. 28;

Fig. 30 is a perspective view of the battery cover of the ninth embodiment, in a position for a somewhat thicker battery; and

Fig. 31 is a cross-sectional elevation view the cover, corresponding to Fig. 30.

### DESCRIPTION OF PREFERRED EMBODIMENTS

The accompanying drawings illustrate various aspects and exemplary embodiments to accommodate batteries of different sizes, the eight exemplary embodiments being in accordance with the invention as claimed.

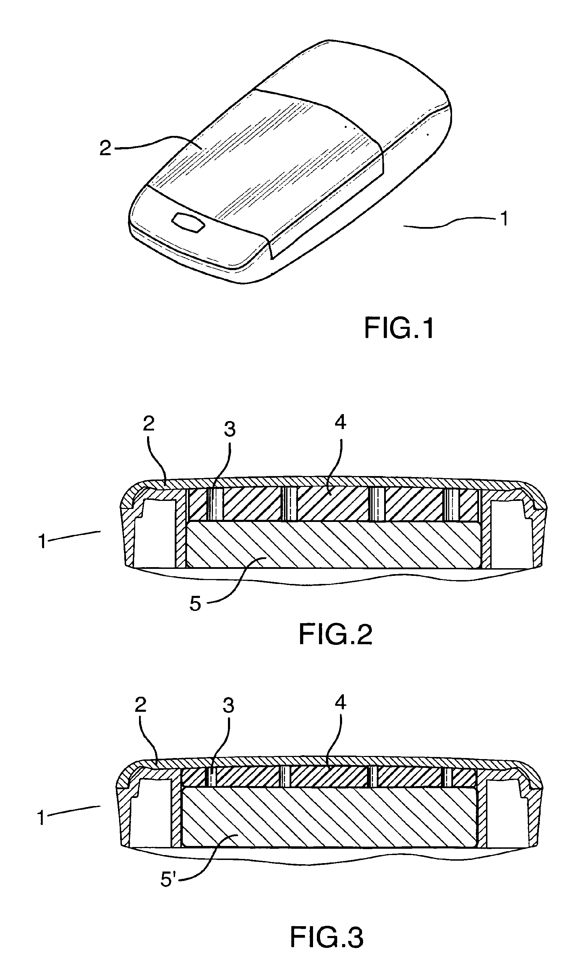

According to a first exemplary embodiment, as shown in Figs. 1-3, the handheld device **1** with a cover **2** secured to the device by any suitable conventional means, over a battery compartment **3**. Inside the battery compartment, under the cover, are one or more elastomeric elements **4** which bear against an installed battery, **5** or **5'**. Fig. 2 shows a relatively thin battery **5**, such that the elastomeric elements are not compressed, or are compressed only sufficiently to keep the battery in position. Fig. 3 shows a somewhat thicker battery **5'**, such that the elastomeric elements are somewhat compressed, the compression creating more space to accommodate the larger battery.

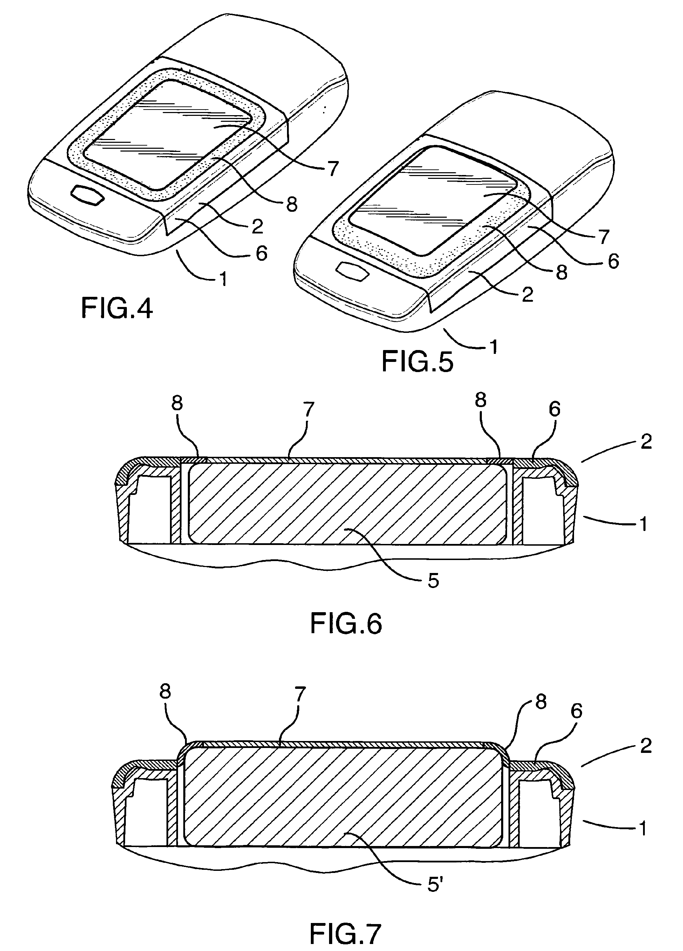

According to a second exemplary embodiment, as shown in Figs. 4-7, the handheld device **1** has a cover **2** secured to the device by any suitable conventional means, over the battery compartment **3**. The cover has a generally rigid outer frame **6**, for example of hard plastic or metal, and a generally rigid centre portion **7**, again for example of hard plastic or metal. The outer frame and centre portion are connected by an elastomeric web portion **8**, molded with or otherwise connected to both the outer frame and the centre portion. As can be seen from a comparison between Figs. **4** and **5**, or especially between Figs. 6 and 7, the centre portion **7** is in one position in Figs. 4 and 6, relatively flat or generally co-planar with the outer frame **6** for example, to accommodate a relatively thin battery **5**. In Figs. 5 and 7, the elastomeric web **8** is stretched, and the centre portion **7** is displaced outwardly, thereby accommodating a somewhat thicker battery **5'**.

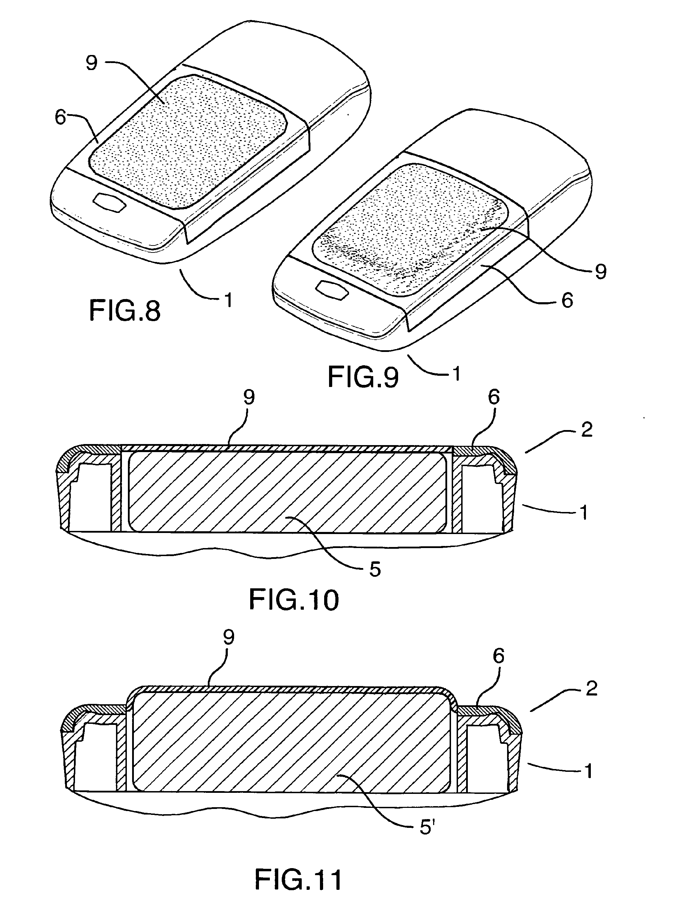

A third exemplary embodiment, similar to the second embodiment, is shown in Figs. 8-11. In this embodiment, there is no generally rigid centre portion. Instead, there is an elastomeric portion **9** secured to the outer frame **6**, spanning across the battery compartment. As can be seen from a comparison between Figs. 8 and 9, or especially between Figs. 10 and 11, the elastomeric portion **9** is in one position in Figs. 8 and 10, relatively flat or generally co-planar with the outer frame **6** for example, to accommodate a relatively thin battery **5**. In Figs. 9 and 11, the elastomeric portion **9** is stretched, particularly towards outer edges thereof, thereby accommodating a somewhat thicker battery **5'**.

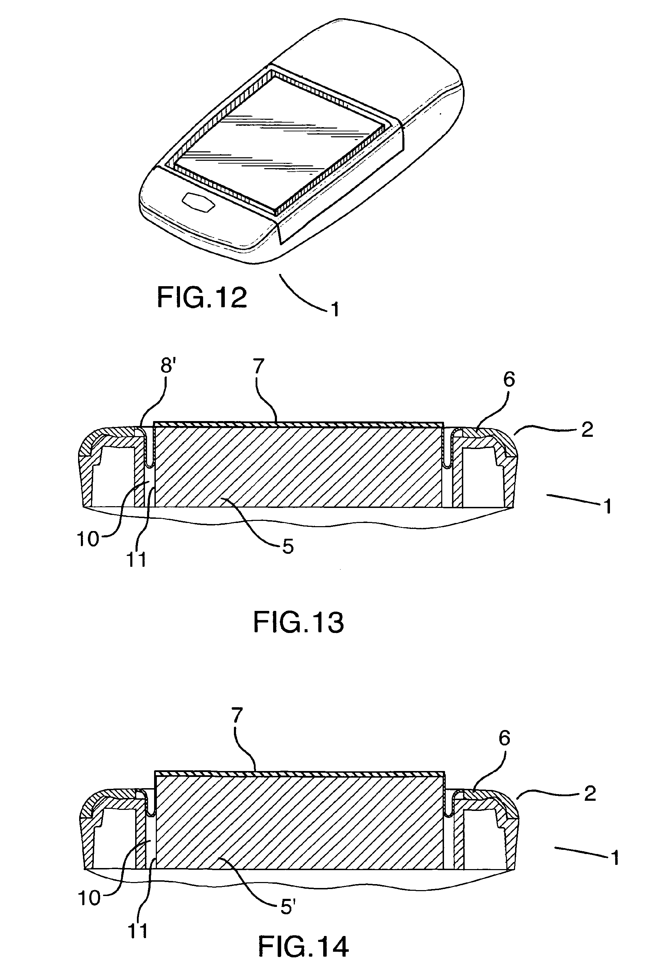

A fourth exemplary embodiment, also similar to the second embodiment, is shown in Figs. 12-14. In this embodiment, the cover again has a generally rigid outer frame **6** and a generally rigid centre portion **7**, and the outer frame and centre portion are again connected by an elastomeric web portion. However, the elastomeric web portion **8'**, is in the form of a flexible membrane, molded with or otherwise connected to both the outer frame and the centre portion. The membrane tucks into a small gap **10** between the battery **5** or **5'** and the side wall **11** of the battery compartment. As with the previous embodiments, Figs. 13 and 14 show the comparison between accommodating a relatively thin battery **5** and a somewhat thicker battery **5'**.

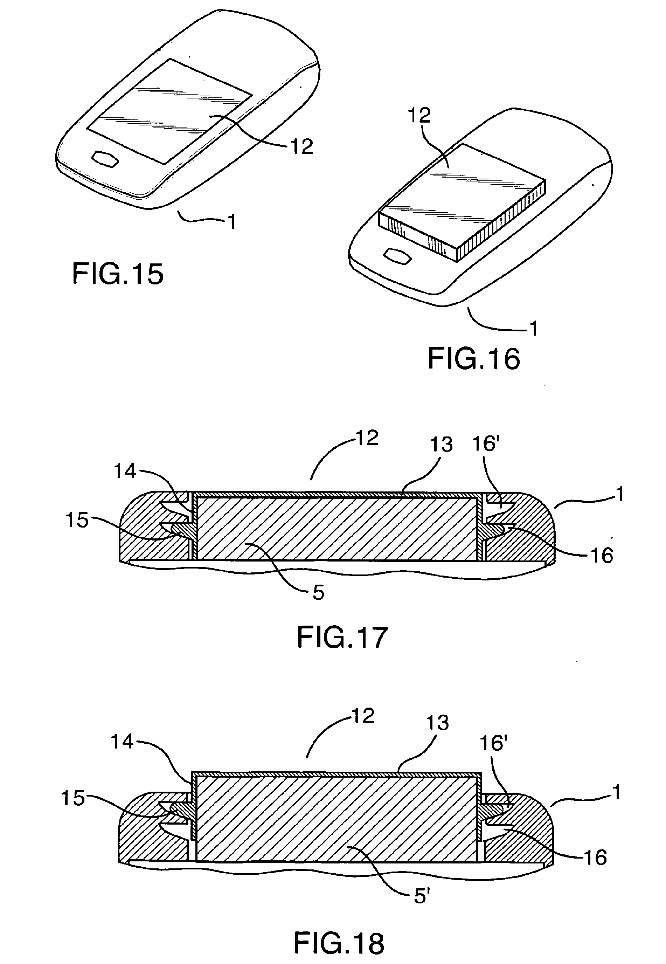

A fifth exemplary embodiment is shown in Figs. 15-18. In this embodiment, a battery cover **12** has an outer surface **13** and side walls **14** encompassing the battery **5** or **5'**. The battery cover preferably is generally rigid, but could be somewhat flexible. Extending outwardly from the side walls **14** are flexible engagement means **15** such as elastomeric or otherwise flexible tabs or a flange, which can engage corresponding recesses **16** or **16'** at two or more relative heights. The battery cover is installed by pressing it downwardly into the battery compartment, such that the flexible engagement means snap or pop into the relevant recess or recesses. One recess height, shown in Fig. 17, corresponds to a relatively thin battery **5**, while the other recess height, shown in Fig. 18, corresponds to a somewhat thicker battery **5'**. There could be additional recess heights if desired. The flexible engagement means **15** could be tabs placed at several locations around the circumference of the battery cover, with recesses at corresponding locations, or could be in the form of a continuous flange extending all the way around the battery cover. The tabs or flange could be integral to the battery cover, or could be a separate piece. Although elastomeric tabs or an elastomeric flange are primarily contemplated, it should be appreciated that analogous means could be employed instead. For example, the battery cover could be provided with a ball-spring arrangement, to engage detents at different heights in the battery compartment, or the reverse could be provided, i.e. ball-spring arrangements in the battery compartment, engaging detents in the side walls of the battery cover.

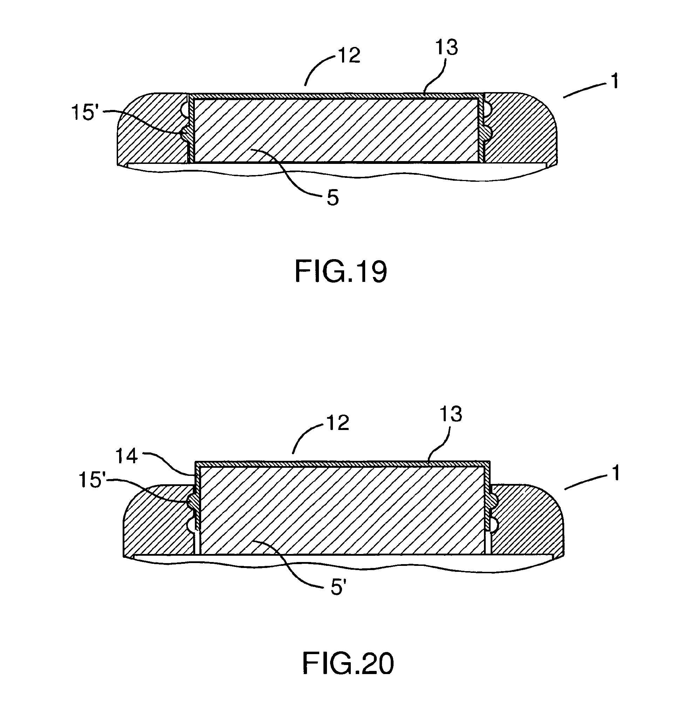

Figs. 19 and 20 show a sixth exemplary embodiment, very similar to the preceding embodiment, in which the flexible engagement means **15** is in the form of elastomeric dimples engaging corresponding recesses. The ball-spring arrangement referred to above would be somewhat similar in concept and appearance.

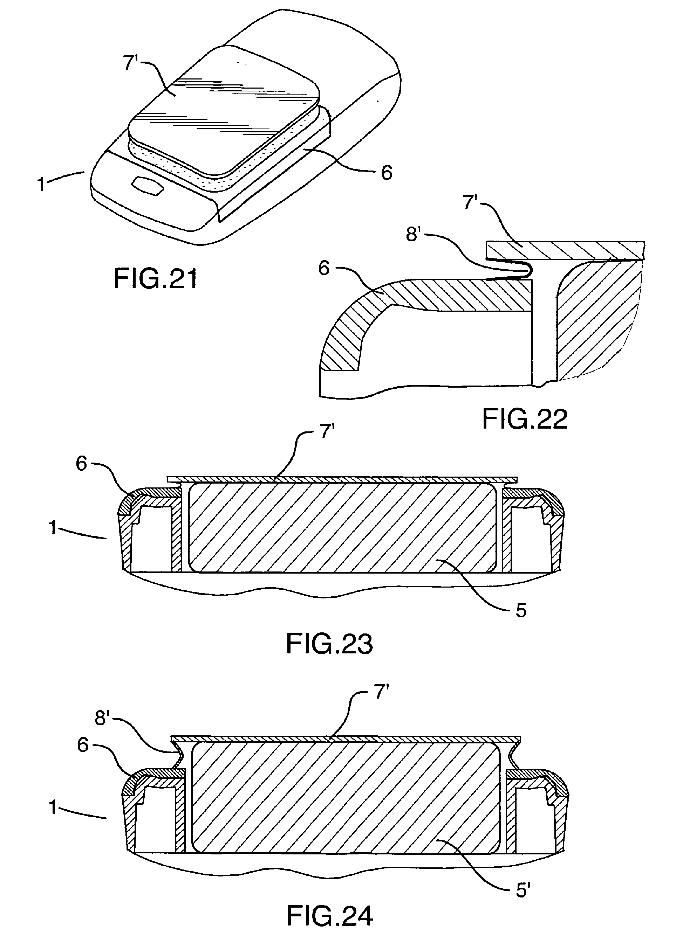

Figs. 21-24 show a seventh exemplary embodiment, similar in concept to the second and fourth embodiments in particular. In this embodiment, the cover has a generally rigid outer frame **6**, for example of hard plastic or metal, and a generally rigid centre portion **7'**, again for example of hard plastic or metal. The outer frame and centre portion are connected by a web portion **8'**, molded with or otherwise connected to both the outer frame and the centre portion. This web portion **8**' is of a springy material, biased to the position shown in Fig. 23. To accommodate a somewhat thicker battery **5'**, the web portion 8' expands outwardly as shown in Fig. 24.

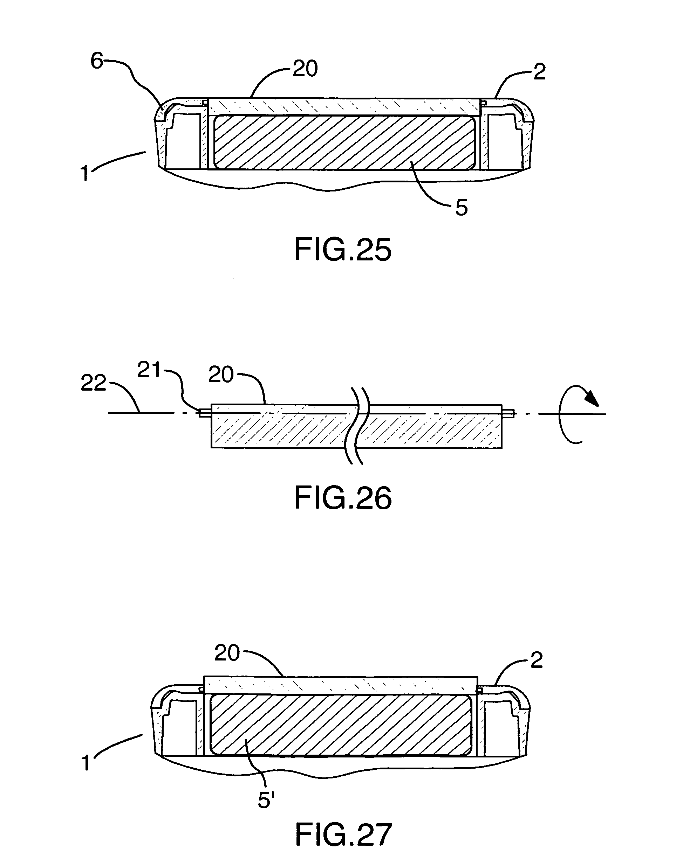

Figs. 25-27 show an eighth exemplary embodiment, which is in accordance with the invention as claimed and in which the battery cover **20** itself, or a portion thereof, is reversible and has tabs or flanges **21** displaced from the centreline **22**. As can be seen from comparing Figs. 25 and 27, flipping the cover or cover portion thus creates a smaller or larger space for the battery **5** or **5'**.

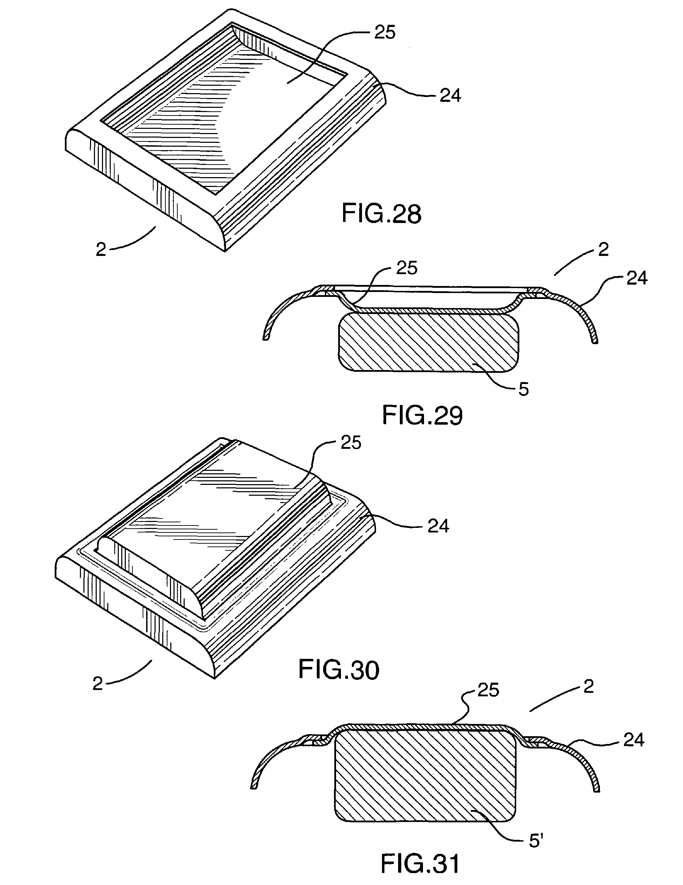

Figs. 28-31 show a ninth exemplary embodiment, in which the battery cover **2** is in two pieces, namely an outer frame **24**, and a central portion **25**. As can be readily seen from the drawings, the centre portion can be installed in one of two positions, according to a principle somewhat similar to the preceding embodiment. Depending on which orientation is used, a smaller or larger space for the battery **5** or **5'** is created.

The eight embodiment illustrates various aspects of the invention, but as example only. It will be appreciated that many additional variations and examples are possible, and will be apparent to those knowledgeable in the field of the invention. Thus the scope of the invention, as defined in the following claims, is not limited to this specific example.

Without limiting the generality of the foregoing, further aspects may include, for example, any other obvious variations as to how the battery cover may be configured or installed to provide varying battery compartment sizes; any obvious variations in choices of materials, degree of flexibility or resilience, if any, and any obvious variations in size, shape or other characteristics not relevant to the point of the invention. It should also be noted that although certain of the exemplary embodiments above lend them selves to discrete battery sizes only, others (for example embodiments with elastomeric elements) may lend themselves to a variety of battery sizes, along a continuum).

A portion of the disclosure of this document contains material which is subject to copyright protection. The copyright owner has no objection to the facsimile reproduction by anyone of the patent document or disclosure, as it appears in the Patent Office file or public records, but otherwise reserves all copyright protection whatsoever.

## Claims

1. A portable electronic device (1) comprising a battery compartment (3) and a removable cover (2) therefor, said battery compartment (3) and cover (2) being configured to engage each other in one of at least two discrete relative positions, each said position providing a different battery compartment depth to accommodate batteries (5,5') of different sizes, wherein said cover (2) has a generally rigid outer frame (6) and a generally rigid centre portion (20) securable to said outer frame in either one of at least two positions, each said position corresponding to a different battery thickness.

2. The device of Claim 1, wherein said cover (2) has engagement elements (21) extending outwardly therefrom, to engage recesses in side walls of said battery compartment, said engagement elements located away from a centre plane (22) of said cover, whereby rotation of said cover between alternate orientations about an axis in the plane of the cover produces a smaller battery compartment in one orientation than in the other orientation.

## Patentansprüche

1. Tragbare elektronische Vorrichtung (1), die ein Batteriefach (3) und eine abnehmbare Abdeckung (2) dafür umfasst, wobei das Batteriefach (3) und die Abdeckung (2) ausgebildet sind, um in einer von mindestens zwei diskreten relativen Positionen ineinander einzugreifen, wobei jede der Positionen eine andere Batteriefachtiefe zum Aufnehmen von Batterien (5, 5') in verschiedenen Größen aufweist, wobei die Abdeckung (2) einen allgemein steifen Außenrahmen (6) und einen allgemein steifen Mittelabschnitt (20) aufweist, der in einer der mindestens zwei Positionen an dem Außenrahmen befestigt werden kann, wobei jede der Positionen einer anderen Batteriedicke entspricht.

2. Vorrichtung nach Anspruch 1, wobei die Abdeckung (2) Eingriffselemente (21) aufweist, die sich davon nach außen erstrecken, um in Vertiefungen in Seitenwänden des Batteriefachs einzugreifen, wobei die Eingriffselemente entfernt von einer Mittelebene (22) der Abdeckung angeordnet sind, wobei eine Drehung der Abdeckung zwischen wechselnden Ausrichtungen um eine Achse in der Ebene der Abdeckung in einer Ausrichtung ein kleineres Batteriefach erzeugt als in der anderen Ausrichtung.

## Revendications

1. Un dispositif électronique portatif (1) comprenant un compartiment pour batteries (3) et un couvercle amovible (2) pour celui-ci, lesdits compartiment pour batteries (3) et couvercle (2) étant configurés de façon à entrer en contact mutuellement dans l'une d'au moins deux positions relatives, chacune desdites positions fournissant une profondeur de compartiment pour batteries différente de façon à loger des batteries (5, 5') de tailles différentes, où ledit couvercle (2) possède une structure extérieure généralement rigide (6) et une partie centrale généralement rigide (20) fixable à ladite structure extérieure dans l'une quelconque d'au moins deux positions, chacune desdites positions correspondant à une épaisseur de batterie différente.

2. Le dispositif selon la Revendication 1, où ledit couvercle (2) possède des éléments de mise en contact (21) s'étendant vers l'extérieur de celui-ci destinés à entrer dans des évidements placés dans des parois latérales dudit compartiment pour batteries, lesdits éléments de mise en contact étant placés à distance d'un plan central (22) dudit couvercle, grâce à quoi la rotation dudit couvercle entre des orientations alternées autour d'un axe du plan du couvercle produit un compartiment pour batteries plus petit dans une orientation que dans l'autre orientation.
